# DEMANDE DE BREVET EUROPEEN

(11) **EP 4 391 757 A1**
(43) Date de publication de la demande: **26.06.2024**
(21) Numéro de dépôt: 23217280.9
(22) Date de dépôt: 15.12.2023
(51) Int. Cl.: H05K 7/20, H01L 23/40, H05K 1/02

(54) **ELECTRICAL EQUIPMENT**

(30) Priorité: 19.12.2022 FR 2213753
(71) Demandeur: Valeo eAutomotive France SAS, 95892 Cergy Pontoise (FR)
(72) Inventeur: PARIGOT, Baptiste, 95892 CERGY PONTOISE (FR)
(74) Mandataire: Valeo Powertrain Systems

(57) **Abrégé**

La présente invention concerne un équipement électrique (1), comprenant :
- une carte électronique (3),
- un composant électronique (5a), le composant électronique (5a) étant soudé sur la carte électronique (3) et disposé parallèlement à la carte électronique (3),
- un dissipateur thermique (7), lequel est configuré pour dissiper la chaleur émise par le composant électronique (5a),
- un organe de maintien (9a), lequel porte un élément d'appui (27a), l'élément d'appui (27a) appuyant sur le composant électronique (5a) selon une direction orthogonale à la carte électronique (3) et selon un sens d'éloignement du composant électronique (5a) relativement à la carte électronique (3), l'élément d'appui (27a) étant configuré pour appuyer le composant électronique (5a) sur le dissipateur thermique.

## Description

La présente invention se rapporte au domaine des équipements électriques, notamment pour véhicules, par exemple pour véhicules électriques ou hybrides, et concerne plus particulièrement un équipement électrique, notamment un chargeur électrique, un convertisseur de tension, ou un onduleur.

L'invention vise notamment à simplifier l'assemblage de l'équipement électrique.

On connaît déjà dans l'état la technique un équipement électrique, notamment configuré pour être embarqué dans un véhicule, par exemple à propulsion électrique ou hybride, comprenant une carte électronique et un dissipateur thermique. Le dissipateur thermique sert à dissiper la chaleur émise par un composant électronique soudé sur la carte électronique. Le composant électronique est disposé orthogonalement à la carte électronique et est plaqué contre le dissipateur thermique.

Toutefois, une telle disposition complexifie l'assemblage, du fait que l'accès à la carte électronique du côté du dissipateur thermique n'est pas toujours aisé. En outre, l'encombrement vertical d'une telle disposition - par rapport à la carte électronique - est relativement important.

L'invention a notamment pour but d'obtenir un équipement électrique à encombrement limité permettant un assemblage simple afin de relier thermiquement le composant électronique et le dissipateur thermique.

A cet effet l'invention a pour objet un équipement électrique, comprenant :
- une carte électronique,
- un composant électronique, le composant électronique étant fixé, notamment soudé, sur la carte électronique et disposé parallèlement à la carte électronique,
- un dissipateur thermique, lequel est configuré pour dissiper la chaleur émise par le composant électronique,
- un organe de maintien, lequel porte un élément d'appui, l'élément d'appui appuyant sur le composant électronique selon une direction orthogonale à la carte électronique et selon un sens d'éloignement du composant électronique relativement à la carte électronique, l'élément d'appui étant configuré pour appuyer le composant électronique sur le dissipateur thermique
Ainsi, du fait de la disposition du composant électronique parallèlement à la carte électronique, l'encombrement de l'équipement électrique est limité. Par ailleurs, grâce à cette disposition, du fait de l'appui sur le composant électronique par l'élément d'appui porté par l'organe de maintien, le composant électronique est plaqué de manière simple sur le dissipateur thermique selon une direction orthogonale à la carte électronique. L'assemblage permettant de relier thermiquement le composant électronique et le dissipateur thermique est ainsi réalisé de manière simple.

D'autres caractéristiques optionnelles de l'équipement électrique, prises seules ou en combinaison sont mentionnées ci-après:
Le composant électronique est un transistor ou une diode.

Le composant électronique comporte une pluralité de broches, lesquelles sont uniquement disposées sur un côté du composant électronique, et sont coudées et soudées sur la carte électronique.

Le composant électronique comprend entre deux et cinq broches.

Le composant électronique comporte une puce intégrée dans un support en matériau plastique.

Le composant électronique est conforme à la norme TO-247F, JEDEC août 2022.

L'organe de maintien est disposé sur une face de la carte électronique opposée à la face sur laquelle est disposée le composant électronique. Ainsi, l'assemblage est facilité, du fait que le montage de l'organe de maintien peut être réalisé sans risque d'endommager le composant électronique disposé sur l'autre face de la carte électronique.

L'organe de maintien est en métal, de préférence en acier inoxydable. Ainsi, l'organe de maintien est robuste et peu coûteux.

L'organe de maintien présente une forme de demi-créneau, de sorte qu'une extrémité de l'organe de maintien portant l'élément d'appui est distante de la carte électronique, l'autre extrémité de l'organe de maintien étant supportée par la carte électronique. Ainsi, l'assemblage est facilité. En variante, l'organe de maintien présente une forme essentiellement plane pouvant présenter une bosse. Cette bosse peut être obtenue par exemple par emboutissage de l'organe de maintien durant le processus de fabrication, et peut permettre de mieux rigidifier l'organe de maintien. Dans cette variante, l'entièreté de l'organe de maintien est supportée par la carte électronique.

L'élément d'appui est un pion. Ainsi, l'élément d'appui est réalisé de manière particulièrement simple.

L'organe de maintien est fixé sur le dissipateur thermique, de préférence par vissage au moyen d'une vis de fixation. Ainsi, le positionnement relatif du dissipateur thermique et de l'organe de maintien est facilité, du fait que l'organe de maintien est fixé sur le dissipateur thermique.

L'organe de maintien est supporté par la carte électronique. Ainsi, le positionnement de l'organe de maintien est facilité, du fait qu'il est supporté par la carte électronique.

L'organe de maintien est vissé sur le dissipateur thermique au moyen d'une vis de fixation, la vis de fixation passant à travers un trou de la carte électronique de manière à maintenir ensemble l'organe de maintien, la carte électronique et le dissipateur thermique. Ainsi, le positionnement et la fixation sont facilités.

La carte électronique comprend des moyens de positionnement de l'organe de maintien, de préférence la carte électronique comprenant un trou recevant une patte de positionnement de l'organe de maintien. Ainsi, l'assemblage est facilité, du fait que le positionnement de l'organe de maintien sur la carte électronique est facilité.

L'élément d'appui traverse la carte électronique et appuie directement sur le composant électronique. Ainsi, l'assemblage est facilité, du fait que le montage de l'organe de maintien et de l'élément d'appui peut être réalisé sans risque d'endommager le composant électronique disposé sur l'autre face de la carte électronique. En outre, on dispose d'un équipement particulièrement compact.

L'élément d'appui est encliqueté sur l'organe de maintien ou est surmoulé sur l'organe de maintien. Ainsi, l'assemblage est facilité.

L'élément d'appui est en matériau thermoplastique. Ainsi, l'élément d'appui est réalisé de manière simple et économique.

L'élément d'appui et l'organe de maintien forment une seule pièce, de préférence réalisée en matériau plastique et/ou métallique. Ainsi, l'assemblage est facilité.

Le dissipateur thermique est en métal, de préférence à base d'aluminium. L'utilisation d'aluminium est avantageuse du fait de sa légèreté et de sa capacité à être recyclé.

L'équipement électrique comporte un composant électronique supplémentaire, le composant électronique supplémentaire étant fixé, notamment soudé, sur la carte électronique et disposé parallèlement à la carte électronique, et
l'organe de maintien porte un élément supplémentaire d'appui, l'élément supplémentaire d'appui appuyant sur le composant électronique supplémentaire selon une direction orthogonale à la carte électronique et selon un sens d'éloignement du composant électronique supplémentaire relativement à la carte électronique, l'élément supplémentaire d'appui étant configuré pour appuyer le composant électronique supplémentaire sur le dissipateur thermique. Ainsi, l'assemblage est simplifié, du fait qu'un seul organe de maintien est nécessaire à la fois pour le composant électronique et le composant électronique supplémentaire.

Le composant électronique et le composant électronique supplémentaire sont identiques. Ainsi, la fabrication est facilitée, du fait que le nombre de composants différents est diminué.

L'élément d'appui et l'élément supplémentaire d'appui sont identiques. Ainsi, la fabrication est facilitée, du fait que le nombre de composants différents est diminué.

L'organe de maintien est sous forme de fourche, une première branche de la fourche portant l'élément d'appui, une deuxième branche de la fourche portant l'élément supplémentaire d'appui, un tronc de la fourche étant supporté par la carte électronique. Ainsi, l'assemblage est simplifié, du fait qu'un seul organe de maintien est réalisé de manière particulièrement simple à la fois pour le composant électronique et le composant électronique supplémentaire, et le positionnement relatif des éléments d'appui est simplifié.

Une fourche se présente généralement sous la forme d'un tronc, constituant une première extrémité libre, et deux branches formant deux autres extrémités libres de la forme prenant naissance dans une même zone du tronc, les deux branches n'étant pas symétriques par rapport à la zone du tronc d'où elles prennent naissance.

Cet organe de maintien peut être monobloc ou être formé de plusieurs parties directement adjacentes les unes des autres.

L'équipement électrique est configuré pour être embarqué dans un véhicule.

L'équipement électrique est configuré pour être embarqué dans un véhicule, et forme :
- un convertisseur courant continu - courant continu configuré pour convertir une tension entre une batterie d'alimentation haute tension et une batterie d'alimentation basse tension, ou
- un chargeur électrique configuré pour convertir une tension entre un réseau électrique extérieur au véhicule et une batterie d'alimentation du véhicule, ou
- un onduleur configuré de manière à alimenter un moteur électrique entraînant le véhicule depuis une batterie d'alimentation, l'onduleur étant configuré pour convertir du courant continu fourni par la batterie d'alimentation en un courant alternatif d'alimentation du moteur électrique et inversement.

L'équipement électrique formant un onduleur est par exemple monté avec une machine électrique tournante comprenant un rotor et un stator. La machine électrique tournante peut, avantageusement, former un alternateur, un alterno-démarreur, une machine réversible ou un moteur électrique.

Le courant alternatif est par exemple un courant monophasé ou triphasé.

La basse tension est comprise entre 5 et 50 Volts, de préférence égale à 12 ou 48 Volts.

La haute tension est comprise entre 220 et 1500 Volts, de préférence égale à 400 ou 800 Volts.

### Brève description des figures

L'invention sera mieux comprise à la lecture de la description qui va suivre donnée uniquement à titre d'exemple et faite en se référant aux dessins annexés dans lesquels :
[Fig. 1] est une vue schématique en coupe d'un équipement électrique selon un mode de réalisation de l'invention ;
[Fig. 2] est une vue schématique en perspective de dessus d'une partie d'un équipement électrique représenté sur la figure 1 ;
[Fig. 3] est une vue schématique en perspective de dessous d'une partie d'un équipement électrique représenté sur la figure 1 ;
[Fig. 4] est une vue schématique en perspective de dessous d'une partie d'un équipement électrique représenté sur la figure 1, dans laquelle certains éléments ne sont pas représentés afin de rendre visibles certaines caractéristiques de l'équipement électrique.
[Fig. 5] est une vue schématique en perspective d'un organe de maintien d'un équipement électrique représenté sur la figure 1.

Sur ces figures, les éléments analogues sont désignés par des références identiques.

### Description détaillée

Les modes de réalisations suivants sont des exemples. Bien que la description se réfère à un ou plusieurs modes de réalisation, ceci ne signifie pas nécessairement que chaque référence concerne le même mode de réalisation, ou que les caractéristiques s'appliquent uniquement à un seul mode de réalisation. De simples caractéristiques de différents modes de réalisation peuvent également être combinées ou interchangées pour fournir d'autres modes de réalisation.

Dans la description, on peut indexer certains éléments, par exemple premier élément ou deuxième élément. Dans ce cas, il s'agit d'un simple indexage pour différencier et dénommer des éléments proches mais non identiques. Cette indexation n'implique pas une priorité d'un élément par rapport à un autre et on peut aisément interchanger de telles dénominations sans sortir du cadre de la présente invention. Cette indexation n'implique pas non plus un ordre dans le temps.

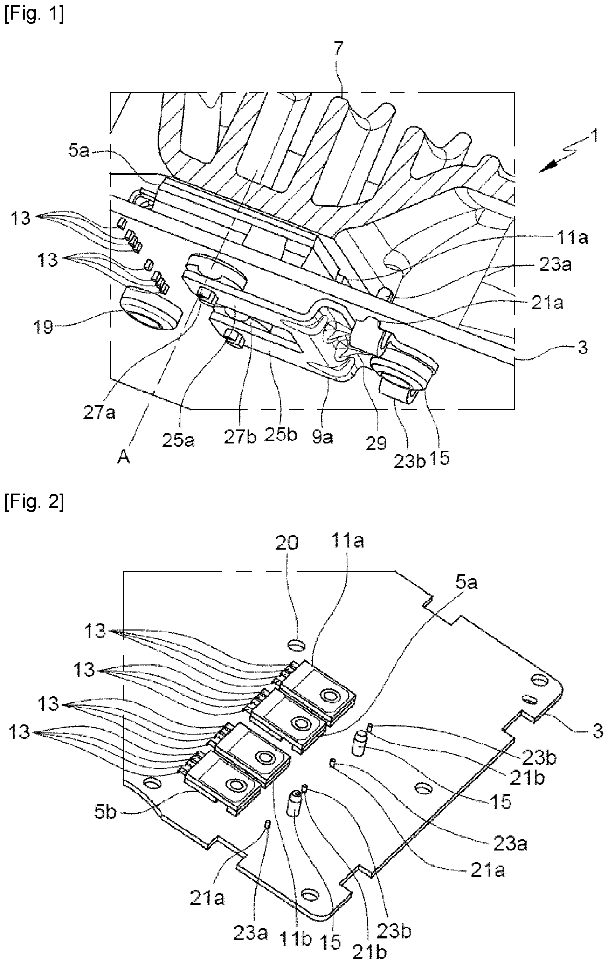

On a représenté partiellement en coupe sur la figure 1 un équipement électrique selon un mode de réalisation, désigné par la référence générale 1.

L'équipement électrique 1 représenté en coupe sur la figure 1 comprend une carte électronique 3, au moins un composant électronique 5a soudé sur la carte électronique 3 et disposé parallèlement à la carte électronique 3, un dissipateur thermique 7 et au moins un organe de maintien 9a.

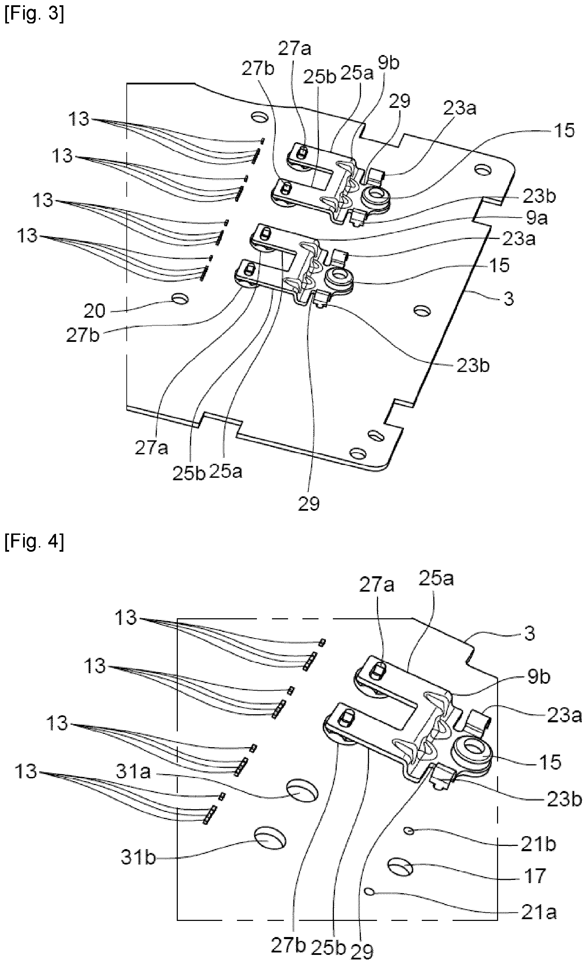

Dans cet exemple, l'équipement électrique 1 comprend également au moins un composant électronique 11a supplémentaire soudé sur la carte électronique 3 et disposé parallèlement à la carte électronique 3. Dans cet exemple, ledit au moins un composant électronique 11a supplémentaire est identique audit au moins un composant électronique 5a. Plus précisément dans cet exemple, l'équipement électronique 1 comprend deux composants électroniques 5a, 5b et deux composants électroniques 11a, 11b supplémentaires, tous identiques et représentés notamment sur la figure 2, et deux organes de maintien 9a, 9b identiques, lesquels sont représentés notamment sur la figure 3. La carte électronique 3 comprend classiquement d'autres composants électriques ou électroniques, lesquels ne sont pas représentés sur les figures.

Le dissipateur thermique 7 est configuré pour dissiper la chaleur émise par le composant électronique 5a, 5b, et est configuré pour dissiper la chaleur émise par le composant électronique supplémentaire 11a, 11b. Par exemple, le dissipateur thermique 7 est en métal, de préférence à base d'aluminium.

Dans cet exemple, le composant électronique 5a, 5b comporte une pluralité de broches 13, lesquelles sont uniquement disposées sur un côté du composant électronique 5a, 5b, et sont coudées et soudées sur la carte électronique 3. Par exemple, le composant électronique 5a, 5b comprend entre deux et cinq broches, dans cet exemple quatre broches 13. Par ailleurs, le composant électronique 5a, 5b comporte une puce intégrée dans un support en matériau plastique, et est par exemple conforme à la norme TO-247F, JEDEC août 2022. Par exemple, le composant électronique 5a, 5b est un transistor ou une diode.

Dans cet exemple, le composant électronique supplémentaire 11a, 11b comporte une pluralité de broches 13, lesquelles sont uniquement disposées sur un côté du composant électronique 11a, 11b, et sont coudées et soudées sur la carte électronique 3. Par exemple, le composant électronique supplémentaire 11a, 11b comprend entre deux et cinq broches, dans cet exemple quatre broches 13. Par ailleurs, le composant électronique supplémentaire 11a, 11b comporte une puce intégrée dans un support en matériau plastique, et est par exemple conforme à la norme TO-247F, JEDEC août 2022. Par exemple, le composant électronique supplémentaire 11a, 11b est un transistor ou une diode. Ainsi dans cet exemple, le composant électronique supplémentaire 11a, 11b est identique au composant électronique 5a, 5b.

Par exemple, l'ensemble de composants électroniques 5a, 5b et de composants électroniques supplémentaires 11a, 11b forme un pont redresseur de tension pour transformer la tension alternative générée par des phases d'un stator en une tension continue et/ou, à l'inverse, pour transformer une tension continue en une tension alternative pour alimenter les phases du stator.

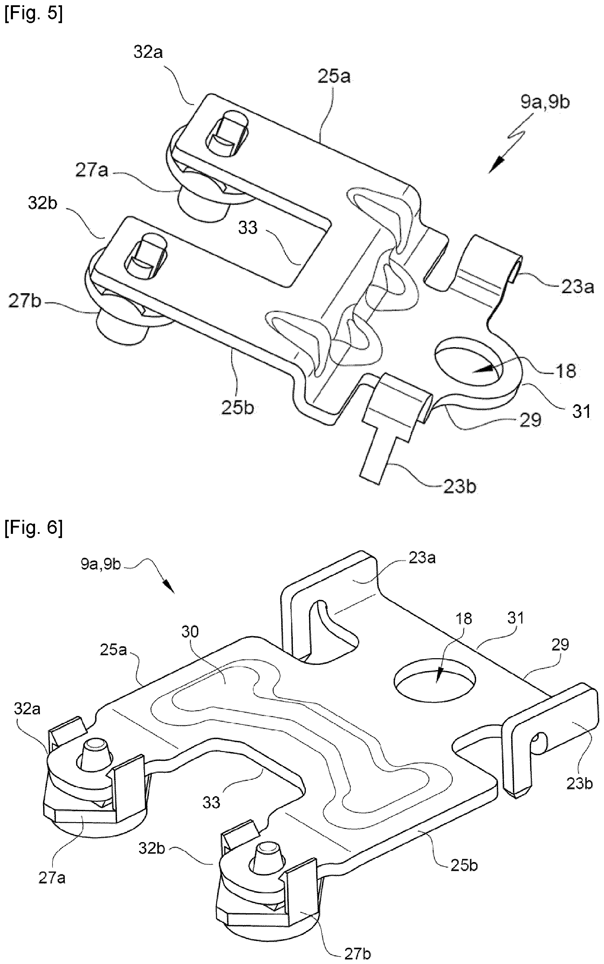

L'organe de maintien 9a, 9b est supporté par la carte électronique 3. Plus précisément, l'organe de maintien 9a, 9b est disposé sur une face de la carte électronique 3 opposée à la face sur laquelle est disposée le composant électronique 5a, 5b. Par ailleurs, dans cet exemple, l'organe de maintien 9a, 9b est fixé sur le dissipateur thermique 7, de préférence par vissage au moyen d'une vis de fixation 15. Ainsi, dans cet exemple, l'organe de maintien 9a, 9b est vissé sur le dissipateur thermique 7 au moyen d'une vis de fixation 15, la vis de fixation 15 passant à travers un trou 17 de la carte électronique 3, représenté sur la figure 4 sur laquelle l'organe de maintien 9a est volontairement non représenté, de manière à maintenir ensemble l'organe de maintien 9a, 9b, la carte électronique 3 et le dissipateur thermique 7. Dans cet exemple, la vis de fixation 15 passe également à travers un trou 18 de l'organe de maintien 9a, 9b, visible sur la figure 5.

Par exemple, la carte électronique 3 est vissée sur le dissipateur thermique 7 au moyen d'une vis de fixation 19, la vis de fixation 19 passant à travers un trou 20 de la carte électronique 3.

Dans cet exemple, la carte électronique 3 comprend des moyens de positionnement de l'organe de maintien 9a, 9b. Par exemple, la carte électronique 3 comprend un trou 21a, 21b recevant une patte de positionnement 23a, 23b de l'organe de maintien 9a, 9b. Plus précisément dans cet exemple, l'organe de maintien 9a, 9b comprend deux pattes de positionnement 23a, 23b, la carte électronique 3 comprenant ainsi deux trous 21a, 21b pour chaque organe de maintien 9a, 9b, chaque trou 21a, 21b recevant une patte de positionnement 23a, 23b.

Dans cet exemple, l'organe de maintien 9a, 9b est en métal, de préférence en acier inoxydable. L'organe de maintien 9a, 9b est sous forme de fourche. La fourche se présente sous la forme d'un tronc 29, constituant une première extrémité libre 31, et deux branches 25a, 25b formant deux autres extrémités libres 32a, 32b prenant naissance à partir d'une même zone 33 du tronc, les deux branches 25a, 25b n'étant pas symétriques par rapport à la zone 33 du tronc 29 d'où elles prennent naissance.

En vue du dessus, la fourche peut présenter une forme de U complétée par une queue prenant naissance dans le dos du U. Le tronc 29 peut alors former la queue et le dos du U et chaque branche 25a, 25b de la fourche forme une branche du U. La queue et les branches du U sont ici alignées.

La première branche 25a de la fourche porte un élément d'appui 27a, la deuxième branche 25b de la fourche porte un élément supplémentaire d'appui 27b, et le tronc 29 de la fourche est supporté par la carte électronique 3. Dans cet exemple, l'élément d'appui 27a et l'élément supplémentaire d'appui 27b sont identiques et sont disposés de manière similaire.

Par ailleurs, l'organe de maintien 9a, 9b représenté dans les figures 1 à 5 présente une forme de demi-créneau. Ainsi, une extrémité de l'organe de maintien 9a, 9b portant l'élément d'appui 27a - et l'élément supplémentaire d'appui 27b - est distante de la carte électronique 3, l'autre extrémité de l'organe de maintien 9a, 9b étant supportée par la carte électronique 3.

Dans une variante représentée dans la figure 6, l'organe de maintien 9a, 9b présente une surface essentiellement plane. Dans l'exemple représenté dans la figure 6, l'organe de maintien présente une bosse 30, s'étendant entre les deux branches 25a et 25b, en passant par la zone du tronc 29 d'où prennent naissance les deux branches 25a 25b.

Ainsi, l'organe de maintien 9a, 9b porte un élément d'appui 27a, l'élément d'appui 27a appuyant sur le composant électronique 5a, 5b selon une direction orthogonale à la carte électronique 3 et selon un sens d'éloignement du composant électronique 5a, 5b relativement à la carte électronique 3, comme cela est représenté sur la figure 1 par la flèche A. L'élément d'appui 27a est configuré pour appuyer le composant électronique 5a, 5b sur le dissipateur thermique 7. Pour cela, l'élément d'appui 27a traverse la carte électronique 3, par exemple via un trou 31a dans la carte électronique, et appuie directement sur le composant électronique 5a, 5b. Dans cet exemple, l'élément d'appui 27a est un pion. Par exemple, comme cela est notamment représenté sur la figure 5, l'élément d'appui 27a est encliqueté sur l'organe de maintien 9a, 9b. Par exemple, l'élément d'appui 27a est en matériau thermoplastique. Selon une variante, l'élément d'appui 27a est surmoulé sur l'organe de maintien 9a, 9b. Selon une autre variante, l'élément d'appui 27a et l'organe de maintien 9a, 9b forment une seule pièce, de préférence réalisée en matériau plastique et/ou métallique.

De manière similaire, l'organe de maintien 9a, 9b porte un élément supplémentaire d'appui 27b, l'élément supplémentaire d'appui 27b appuyant sur le composant électronique supplémentaire 11a, 11b selon une direction orthogonale à la carte électronique 3 et selon un sens d'éloignement du composant électronique supplémentaire 11a, 11b relativement à la carte électronique 3. L'élément supplémentaire d'appui 27b est configuré pour appuyer le composant électronique supplémentaire 11a, 11b sur le dissipateur thermique 7. Pour cela, l'élément supplémentaire d'appui 27b traverse la carte électronique 3, par exemple via un trou 31b dans la carte électronique, et appuie directement sur le composant électronique supplémentaire 11a, 11b. Par exemple, l'élément supplémentaire d'appui 27b est encliqueté sur l'organe de maintien 9a, 9b. Dans cet exemple, l'élément supplémentaire d'appui 27b est un pion. Par exemple, l'élément supplémentaire d'appui 27b est en matériau thermoplastique. Selon une variante, l'élément d'appui 27b est surmoulé sur l'organe de maintien 9a, 9b. Selon une autre variante, l'élément supplémentaire d'appui 27b et l'organe de maintien 9a, 9b forment une seule pièce, de préférence réalisée en matériau plastique et/ou métallique.

Un équipement électrique 1 tel que précédemment décrit est configuré pour être embarqué dans un véhicule, et forme :
- un convertisseur courant continu - courant continu configuré pour convertir une tension entre une batterie d'alimentation haute tension et une batterie d'alimentation basse tension, ou
- un chargeur électrique configuré pour convertir une tension entre un réseau électrique extérieur au véhicule et une batterie d'alimentation du véhicule, ou
- un onduleur configuré de manière à alimenter un moteur électrique entraînant le véhicule depuis une batterie d'alimentation, l'onduleur étant configuré pour convertir du courant continu fourni par la batterie d'alimentation en un courant alternatif d'alimentation du moteur électrique et inversement.

Le courant alternatif est par exemple un courant monophasé ou triphasé. La basse tension est comprise entre 5 et 50 Volts, de préférence égale à 12 ou 48 Volts. La haute tension est comprise entre 220 et 1500 Volts, de préférence égale à 400 ou 800 Volts.

Par exemple, l'équipement électrique 1 formant un onduleur est monté dans une machine électrique tournante comprenant un rotor et un stator. La machine électrique tournante peut, avantageusement, former un alternateur, un alterno-démarreur, une machine réversible ou un moteur électrique.

L'invention n'est pas limitée aux modes de réalisation présentés et d'autres modes de réalisation apparaîtront clairement à l'homme du métier. Il est notamment possible de combiner les modes de réalisation et variantes précédemment décrits entre eux.

## Revendications

1. Équipement électrique (1), **caractérisé en ce qu'**il comprend :
- une carte électronique (3),
- un composant électronique (5a, 5b), le composant électronique (5a, 5b) étant fixé, notamment soudé, sur la carte électronique (3) et disposé parallèlement à la carte électronique (3),
- un composant électronique supplémentaire (11a, 11b), le composant électronique supplémentaire (11a, 11b) étant fixé, notamment soudé, sur la carte électronique (3) et disposé parallèlement à la carte électronique (3),
- un dissipateur thermique (7), lequel est configuré pour dissiper la chaleur émise par le composant électronique (5a, 5b),
- un organe de maintien (9a, 9b), lequel porte un élément d'appui (27a) et un élément d'appui supplémentaire (27b), l'élément d'appui (27a) et l'élément d'appui supplémentaire (27b) appuyant sur le composant électronique (5a, 5b) et le composant électronique supplémentaire (11a, 11b) respectivement selon une direction orthogonale à la carte électronique (3) et selon un sens d'éloignement du composant électronique (5a, 5b) relativement à la carte électronique (3), les éléments d'appui (27a, 27b) étant configurés pour appuyer les composant électroniques (5a, 5b, 11a, 11b) sur le dissipateur thermique, l'organe de maintien (9a, 9b) étant en forme de fourche, une première branche (25a) de la fourche portant l'élément d'appui (27a), une seconde branche (25b) de la fourche portant l'élément d'appui supplémentaire (27b), un tronc (39) de la fourche étant supporté par la carte électronique (3).

2. Équipement électrique (1) selon la revendication précédente, dans lequel le composant électronique (5a, 5b) est un transistor ou une diode.

3. Équipement électrique (1) selon l'une quelconque des revendications précédentes, dans lequel l'organe de maintien (9a, 9b) est disposé sur une face de la carte électronique (3) opposée à la face sur laquelle est disposée le composant électronique (5a, 5b).

4. Équipement électrique (1) selon l'une quelconque des revendications précédentes, dans lequel l'organe de maintien (9a, 9b) est fixé sur le dissipateur thermique (7), de préférence par vissage au moyen d'une vis de fixation (15).

5. Équipement électrique (1) selon l'une quelconque des revendications précédentes, dans lequel l'organe de maintien (9a, 9b) est supporté par la carte électronique (3).

6. Équipement électrique (1) selon l'une quelconque des revendications précédentes, dans lequel la carte électronique (3) comprend des moyens de positionnement de l'organe de maintien (9a, 9b), de préférence la carte électronique (3) comprenant un trou (21a, 21b) recevant une patte de positionnement (23a, 23b) de l'organe de maintien (9a, 9b).

7. Équipement électrique (1) selon l'une quelconque des revendications précédentes, dans lequel l'élément d'appui (27a) traverse la carte électronique (3) et appuie directement sur le composant électronique (5a, 5b).

8. Équipement électrique (1) selon l'une quelconque des revendications précédentes, dans lequel l'organe de maintien présente une forme de demi-créneau, de sorte qu'une extrémité de l'organe de maintien portant l'élément d'appui est distante de la carte électronique, l'autre extrémité de l'organe de maintien étant supportée par la carte électronique, notamment en étant au contact de la carte électronique.

9. Équipement électrique (1) selon l'une quelconque des revendications 1 à 8, dans lequel l'organe de maintien présente une surface essentiellement plane, pouvant présenter une bosse, l'organe de maintien étant supporté par la carte électronique, notamment en étant au contact de la carte électronique.

10. Équipement électrique (1) selon l'une quelconque des revendications précédentes, l'organe de maintien (9a, 9b) étant monobloc.

11. Équipement électrique (1) selon l'une quelconque des revendications précédentes, configuré pour être embarqué dans un véhicule, et formant :
- un convertisseur courant continu - courant continu configuré pour convertir une tension entre une batterie d'alimentation haute tension et une batterie d'alimentation basse tension, ou
- un chargeur électrique configuré pour convertir une tension entre un réseau électrique extérieur au véhicule et une batterie d'alimentation du véhicule, ou
- un onduleur configuré de manière à alimenter un moteur électrique entraînant le véhicule depuis une batterie d'alimentation, l'onduleur étant configuré pour convertir du courant continu fourni par la batterie d'alimentation en un courant alternatif d'alimentation du moteur électrique et inversement.
